# EUROPÄISCHE PATENTSCHRIFT

(11) **EP 2 209 929 B1**
(45) Veröffentlichungstag und Bekanntmachung des Hinweises auf die Patenterteilung: **21.08.2013**
(21) Anmeldenummer: 08858288.7
(22) Anmeldetag: 04.12.2008
(51) Int. Cl.: C23C 16/38, B03C 3/12, B03C 3/51, B03C 3/74, F01N 3/01, F01N 3/022, F01N 9/00, F01N 3/027

(54) **BESCHICHTETES WERKZEUG**
COATED TOOL
OUTIL REVETU

(30) Priorität: 06.12.2007 AT 73207 U
(43) Veröffentlichungstag der Anmeldung: 28.07.2010
(73) Patentinhaber: Ceratizit Austria GmbH, 6600 Reutte (AT)
(72) Erfinder: WALLGRAM, Wolfgang, A-6600 Breitenwang (AT); SCHLEINKOFER, Uwe, A-6600 Reutte (AT); GIGL, Karl, A-6682 Vils (AT); THURNER, Josef, A-6611 Heiterwang (AT)
(86) Internationale Anmeldenummer: PCT/AT2008/000430
(87) Internationale Veröffentlichungsnummer: WO 2009/070820

(56) Entgegenhaltungen:
- DD-A1- 144 930
- US-A1- 2006 051 618
- PIERSON H O ET AL: "The chemical vapor deposition of TiB2 from diborane" THIN SOLID FILMS, ELSEVIER-SEQUOIA S.A. LAUSANNE, CH, Bd. 72, Nr. 3, 15. Oktober 1980 (1980-10-15), Seiten 511-516, XP024574685 ISSN: 0040-6090 [gefunden am 1980-10-15]
- CAPUTO A J ET AL: "CHEMICAL VAPOR DEPOSITION OF EROSION-RESISTANT TiB2 COATINGS." ELECTROCHEMICAL SOCIETY EXTENDED ABSTRACTS 1984 ELECTROCHEMICAL SOC INC, Bd. 84-1, 1984, Seite 288, XP002521751
- SEIJI MOTOJIMA ET AL: "CHEMICAL VAPOUR DEPOSITION OF TIB2 PROTECTIVE LAYERS ON A BRASS PLATE" JOURNAL OF MATERIALS SCIENCE, SPRINGER / BUSINESS MEDIA, DORDRECHT, NL, Bd. 23, Nr. 12 + INDEX, 1. Dezember 1988 (1988-12-01), Seiten 4375-4378, XP000009259 ISSN: 0022-2461
- DATABASE WPI Week 198403 Thomson Scientific, London, GB; AN 1984-015408 XP002521755 & JP 58 209554 A (HITACHI METALS LTD) 6. Dezember 1983 (1983-12-06)

## Beschreibung

Die Erfindung betrifft einen beschichteten Gegenstand, bestehend aus einem Substratmaterial und aus einer ein- oder mehrlagigen Hartstoffschicht, wobei die Hartstoffschicht mindestens eine durch ein thermisches CVD-Verfahren abgeschiedene, mindestens 0,1 µm dicke Titandiboridschicht umfasst.

Es ist bekannt, ein- oder mehrlagige Hartstoffschichten, welche zumindest eine Titandiboridschicht umfassen, durch verschiedene Beschichtungsverfahren, wie PVD (Physical Vapor Deposition), CVD (Chemical Vapor Deposition) oder auch mit plasmaunterstützten CVD-Verfahren (P-CVD, ICP-PVD) abzuscheiden.

Wenn man allgemein von CVD-Verfahren spricht, ist in der Regel das thermische CVD-Verfahren gemeint, bei dem in einem Rezipienten bei einem Temperaturbereich oberhalb 700 bis 750°C unter Normaldruck oder Unterdruck mit Hilfe eines sich bei den Beschichtungstemperaturen zersetzenden Gasgemisches der Reaktionskomponenten eine entsprechende Hartstoffschicht auf dem Substrat abgeschieden wird.

Beim plasmaunterstützten CVD-Verfahren zersetzen sich die Reaktionskomponenten des Gasgemisches durch ein im Reaktionsraum angelegtes Plasma sowie durch Einwirken der Temperatur. Das Plasma kann dabei beispielsweise durch Hochfrequenz (P-CVD) oder durch Induktion (ICP-CVD = Inductively Coupled Plasma CVD) erzeugt werden. Dabei treten deutlich niedrigere Temperaturen als beim thermischen CVD-Verfahren im Bereich von etwa 400 bis 600°C auf, so dass auch Substrate beschichtet werden können, deren Gefüge durch zu hohe Temperatureinwirkung verändert werden könnte. Die plasmaunterstützten CVD-Verfahren sind mit einem hohen verfahrenstechnischen und apparativen Aufwand verbunden und haben sich zur wirtschaftlichen Beschichtung von verschleißfesten Massenteilen, wie beispielsweise Wendeschneidplatten zur Zerspanung in der Praxis bis heute nicht durchgesetzt.

Beim PVD-Verfahren werden die zu beschichtenden Substrate in einem Temperaturbereich zwischen 300 bis 500°C durch physikalisches Abtragen einer geeigneten Beschichtungsquelle und durch Einbringen einer reaktiven Gaskomponente mit der gewünschten Hartstoffschicht beschichtet.

Verschleißfeste Gegenstände bei denen bisher eine Hartstoffschicht mit einer Titandiboridschicht über ein thermisches CVD-Verfahren hergestellt wurden, weisen zwischen Substratmaterial und Titandiboridschicht oder auch vielfach zwischen Titandiboridschicht und einer darunter liegenden anderen Hartstoffschicht eine borhaltige Diffusionszone auf. Diese Diffusionszone führt zu einer Versprödung dieses Bereiches, eventuell verbunden mit einer schlechten Haftfestigkeit der Titandiboridschicht und damit zu einer verringerten Verschleißfestigkeit des beschichteten Gegenstandes. Aus diesem Grund wurden verschleißfeste Teile, insbesondere Schneideinsätze für die spanabhebende Bearbeitung mit einer Titandiboridschicht in den überwiegenden Fällen mittels PVD-Verfahren beschichtet, obwohl PVD-Verfahren gegenüber thermischen CVD-Verfahren in der Regel mit höheren Herstellkosten verbunden sind.

Titandiboridschichten, welche mit einem PVD-Verfahren abgeschieden werden, weisen eine texturierte Schichtstruktur mit einem stängelförmigen Gefüge auf. Die Härte dieser Schichten liegt bei etwa 3.000 (HV 0,03), was insbesondere bei der Zerspanung besonders schwer zerspanbarer Werkstoffe wie Titan, oftmals hinsichtlich der Verschleißbeständigkeit nur bedingt ausreichend ist.

Die DE 25 25 185 beschreibt verschleißfeste Formteile, die aus einem Hartmetallgrundkörper und einer Hartstoffschicht bestehen, wobei die Hartstoffschicht aus zwei übereinander liegenden Teilschichten zusammengesetzt ist, von denen die äußere aus Aluminiumoxid und/oder Zirkonoxid und die innere Teilschicht aus einem oder mehreren Boriden, insbesondere den Diboriden der Elemente Titan, Zirkon, Hafnium, Vanadium, Niob, Tantal, Chrom, Molybdän und Wolfram besteht. In einem Ausführungsbeispiel wird ein Hartmetallkörper in einer ersten Stufe mit einer 3 µm starken Titandiboridschicht versehen. Die Abscheidung dieser Schicht erfolgt bei 1.000°C und einem Druck von 50 Torr, während einer Stunde unter Verwendung eines Gasgemisches aus 1900 I Wasserstoff, 20 ml TiCl₄ sowie 4 g BCl₃.
In einer zweiten Reaktionsstufe wird dann der mit TiB₂ beschichtete Hartmetallkörper mit einer Aluminiumoxidschicht von 5 µm Stärke überzogen. Nachteilig bei diesem Hartmetallkörper ist, dass durch die gewählten Beschichtungsbedingungen zur Abscheidung der Titandiboridschicht Bor in das Hartmetall eindiffundiert. Gleichzeitig bildet sich eine starke eta-Phase und/oder Bor enthaltende spröde Phasen aus, welche die Standzeit des beschichteten Hartmetallkörpers deutlich herabsetzen. Darüber hinaus weist die Titandiboridschicht eine körnige bis säulige Gefügestruktur auf, welche durchschnittliche Korngrößen im µm-Bereich aufweisen.

Die EP 0 015 451 beschreibt einen beschichteten Hartmetallgegenstand mit einer mehrlagigen Hartstoffschicht mit einer äußeren, 5 bis 20 µm starken Schicht aus einem Borid, welches ausgewählt ist aus Titanborid, Hafniumborid, Zirkoniumborid und Tantalborid.
In einem Herstellungsbeispiel wird die Herstellung einer etwa 10 µm dicken Titandiboridschicht, durch Abscheiden aus einem Gasgemisch mit 3,3 Vol.% BCl₃, 2 Vol.% TiCl₄, Rest Wasserstoff bei etwa 800°C und einem Druck von 10⁵Pa in einem Zeitraum von 90 Minuten, beschrieben.
Auch bei einem beschichteten Hartmetallgegenstand der nach diesem Verfahren beschichtet wird, weist die Titandiboridschicht eine körnige bis säulige Gefügestruktur auf, welche durchschnittliche Korngrößen im µm-Bereich aufweist.

Die EP 1 245 693 beschreibt einen Schneideinsatz aus einem Substrat und einer Hartstoffschicht welche mindestens eine Schicht aus Titandiborid aufweist.
Entsprechend den Herstellungsbeispielen in diesem Dokument wird die Titandiboridschicht durch ein PVD-Verfahren hergestellt. Die Titandiboridschicht weist ein faserförmiges Mikrogefüge mit zylindrischen Körnern mit einem Durchmesser im Bereich von 5 bis 50 nm und mit einer Länge von mehr als 260 nm auf. Die zylindrischen Körner sind dabei im Wesentlichen senkrecht zur Substratoberfläche angeordnet.

PIERSON H O ET AL: "The chemical vapor deposition of TiB2 from diborane" THIN SOLID FILMS, ELSEVIER-SEQUOIA S.A. LAUSANNE, CH, Bd. 72, Nr. 3, 15. Oktober 1980 (1980-10-15), Seiten 511-516, offenbart einen Gegenstand bestehend aus einem Substrat und einer Titandiboridschicht mit einer Schichtstärke von 15µm. Die Titandiboridschicht weist eine Korngrösse von 6-26 nm auf.

Aufgabe der Erfindung ist es ein mit einer Hartstoffschicht beschichtetes Werkzeug zu schaffen, dessen Hartstoffschicht eine Titandiboridschicht umfasst, der wirtschaftlich herstellbar ist und im Vergleich zu bekannten Hartstoffschichten mit einer Titandiboridschicht eine deutlich verbesserte Verschleißfestigkeit aufweist.

Erfindungsgemäß wird dies dunch ein Werkzeug gemäß Anspruch 1 erreicht.

Es wurde überraschenderweise erkannt, dass bei verschleißfesten Gegenständen, welche eine Hartstoffschicht mit einer Titandiboridschicht aufweisen, die Verschleißfestigkeit dadurch gesteigert werden kann, wenn diese die erfindungsgemäße Gefügestruktur aufweist.

Die erfindungsgemäße Titandiboridschicht weist eine Härte von über 4300 (HV 0,03) auf, was zu sprunghaftem Anstieg der Verschleißfestigkeit führt. Darüber hinaus ist durch die extreme Feinkörnigkeit die Oberfläche sehr glatt, so dass es insbesondere bei der Zerspanung schwer zerspanbarer Werkstoffe wie Titanlegierungen, kaum zu Verklebungen an der Oberfläche mit den ablaufenden Spänen kommt, wodurch die Bearbeitungssicherheit beträchtlich gesteigert wird.
Wichtig dabei ist, dass eine mittlere Korngröße der Titandiboridschicht von maximal 50 nm nicht überschritten wird, da dann der vorteilhafte Effekt wieder verloren geht.

Weiters ist es vorteilhaft, wenn die Titandiboridschicht im Wesentlichen einphasig vorliegt. Unter im Wesentlichen ist dabei zu verstehen, dass mit den üblichen Phasenbestimmungsmethoden keine weiteren Phasenbestandteile detektiert werden können.

Die erfindungsgemäße Hartstoffschicht kann sowohl als einlagige Titandiboridschicht oder als mehrlagige Hartstoffschicht mit ein oder mehreren Titandiboridschichten im Wechsel mit anderen gebräuchlichen Hartstoffschichten wie Titannitrid, Titankarbid, Titankarbonitrid, Titankarbobornitrid, Aluminiumoxid und dgl. ausgeführt sein.
Als Substratmaterial sind insbesondere Hartmetall und Cermet, aber auch Stahl und Keramik, geeignet.

Besonders vorteilhaft ist es, wenn die Titandiboridschicht eine Schichtstärke im Bereich von 0,1 µm bis 15 µm, insbesondere im Bereich von 1 µm bis 10 µm aufweist. Eine Schichtdicke von unterhalb 0,1 µm würde keine nennenswerte Steigerung der Verschleißfestigkeit des Substratmaterials bewirken, während Schichtdicken von mehr als 15 µm hinsichtlich ihrer Zähigkeit beim Einsatz vor allem in der Metallzerspanung zu spröde wären.

Insbesondere hat es sich bewährt, wenn als Substratmaterial Hartmetall verwendet wird und wenn der beschichtete Gegenstand ein Werkzeug, insbesondere eine Wendeschneidplatte für die spanabhebende Bearbeitung ist.

Wird der beschichtete Gegenstand als Werkzeug für die spanabhebende Bearbeitung ausgeführt, kann es insbesondere von Vorteil sein, wenn die Hartstoffschicht mehrlagig ausgeführt ist und die Titandiboridschicht im Wechsel mit einer oder mehreren gebräuchlichen Hartstoffschichten vorliegt.

Ein besonders vorteilhaftes Werkzeug für die spanabhebende Bearbeitung weist einen Schichtaufbau der Hartstoffschicht auf, der beginnend von der Substratoberfläche aus einer oder mehreren Schichten aus der Gruppe Titannitrid, Titankarbonitrid, und Titankarbobornitrid mit einer Gesamtschichtstärke im Bereich von 0,1 µm bis 3 µm, gefolgt von einer 1 µm bis 5 µm dicken Titandiboridschicht besteht.

Ein anderes, besonders vorteilhaftes Werkzeug für die spanabhebende Bearbeitung weist einen Schichtaufbau der Hartstoffschicht, wie vorhergehend beschrieben auf, wobei zusätzlich noch auf die Titandiboridschicht eine Deckschicht aus einer oder mehreren Schichten aus der Gruppe Titannitrid, Titankarbonitrid und Titankarbobornitrid mit einer Gesamtschichtstärke im Bereich von 0,1 µm bis 3 µm aufgebracht ist.

Von Vorteil ist es auch, wenn die Hartstoffbeschichtung einer Strahlbehandlung mit einem oder mehreren Metallen aus der Gruppe Aluminium, Kupfer, Zink, Titan, Nickel, Zinn oder Basislegierungen dieser Metalle unterzogen wird. Dadurch wird die Gleiteigenschaft der Oberfläche nochmals verbessert, wodurch die Klebeneigung mit den ablaufenden Spänen weiter verringert wird.

Werkzeuge für die spanabhebende Bearbeitung, welche mit einer erfindungsgemäßen Hartstoffschicht versehen sind, sind insbesondere vorteilhaft zur Zerspanung nicht eisenhaltiger Werkstoffe, wie Titan, Aluminium oder deren Legierungen, einsetzbar.
Bei der Bearbeitung dieser Werkstoffe ist insbesondere die aus der feinkörnigen Struktur der Titandiboridschicht resultierende Glätte der erfindungsgemäßen Hartstoffschicht besonders günstig für die Zerspanung dieser Materialien.

Bei einem thermischen CVD-Verfahren zur Herstellung der erfindungsgemäßen Hartstoffschicht bei einer Temperatur im Bereich von 700 bis 900°C wird zur Herstellung der Titandiboridschicht ein Gasgemisch verwendet, welches aus 2,5 bis 50 Vol.% Wasserstoff, 0,1 bis 10 Vol.% TiCl₄, 0,2 bis 20 Vol.% BCl₃, Rest Inertgas, vorzugsweise Argon, besteht.
Mit diesem Verfahren wird die gegenüber dem Stand der Technik deutlich feinkörnigere Struktur der Hartstoffschicht erreicht.

Wenn bei der Gaszusammensetzung die Grenzen der Reaktionskomponenten nach oben überschritten werden, entstehen grobkörnige, ungleichmäßige Schichtstrukturen. Bei einem Unterschreiten der Grenzen entstehen unerwünschte Phasen in der Randzone der zu beschichtenden Substrate.

In einer besonders vorteilhaften Anwendung des erfindungsgemäßen Verfahrens wird zur Herstellung der Titandiboridschicht ein Gasgemisch mit der Zusammensetzung 5 bis 20 Vol.% Wasserstoff, 0,2 bis 1 Vol.% TiCl₄, 0,4 bis 2 Vol.% BCl₃, Rest Inertgas, vorzugsweise Argon, verwendet und erfolgt die Beschichtung unter Normaldruck.
In einer weiteren vorteilhaften Variante des Beschichtungsverfahrens zur Herstellung der erfindungsgemäßen Hartstoffschicht wird vor dem Abscheiden der Titandiboridschicht das Gasgemisch zunächst ohne dem BCl₃-Anteil in den Reaktionsraum eingeleitet und nach einem Zeitraum von 0,5 bis 5 Minuten der BCl₃-Anteil zugemischt. Auf diese Art und Weise wird auch die geringste Diffusion von Bor in den darunter liegenden Werkstoff vermieden.

Im Folgenden wird die Erfindung an Hand von Figuren und Herstellungsbeispielen näher erläutert.

Es zeigen:
- Fig. 1: die Schliffaufnahme einer nach Beispiel 1 erfindungsgemäß beschichteten Wendeschneidplatte in einer lichtmikroskopischen Untersuchung mit etwa 1.500-facher Vergrößerung
- Fig. 2: die Bruchaufnahme des Gefüges der Wendeschneidplatte nach Fig. 1 in einer rasterelektronenmikroskopischen Untersuchung mit etwa 6.000-facher Vergrößerung
- Fig. 3: die Oberflächenaufnahme der Wendeschneidplatte nach Fig. 1 in einer rasterelektronenmikroskopischen Untersuchung mit etwa 6.000-facher Vergrößerung
- Fig. 4: die Gefügeaufnahme der Beschichtung der Wendeschneidplatte nach Fig. 1 in einer transmissionselektronenmikroskopischen (TEM) Untersuchung mit etwa 200.000-facher Vergrößerung
- Fig. 5: die Elektronenbeugungsaufnahme der Beschichtung der Wendeschneidplatte nach Fig.1
- Fig. 6: die Schliffaufnahme einer nach Beispiel 2 nach dem Stand der Technik beschichteten Wendeschneidplatte in einer lichtmikroskopischen Untersuchung in etwa 1.500-facher Vergrößerung
- Fig. 7: das Verschleißdiagramm eines vergleichenden Fräsversuches zwischen einer Wendeschneidplatte die nach Beispiel 1 und einer Wendeschneidplatte die nach Beispiel 2 beschichtet wurde
- Fig. 8: die Bruchaufnahme des Gefüges einer Wendeschneidplatte welche entsprechend Beispiel 3 nach dem Stand der Technik mit einem PVD-Verfahren beschichtet wurde, in einer rasterelektronenmikroskopischen Untersuchung mit etwa 6.000-facher Vergrößerung
- Fig. 9: das Verschleißdiagramm eines vergleichenden Fräsversuches zwischen einer Wendeschneidplatte die nach Beispiel 1 und einer Wendeschneidplatte die nach Beispiel 3 beschichtet wurde
- Fig. 10: die Bruchaufnahme des Gefüges einer Wendeschneidplatte welche entsprechend Beispiel 4 erfindungsgemäß beschichtet wurde in einer rasterelektronenmikroskopischen Untersuchung mit etwa 6.000-facher Vergrößerung
- Fig. 11: die Bruchaufnahme des Gefüges einer Wendeschneidplatte welche entsprechend Beispiel 6 nach dem Stand der Technik beschichtet wurde in einer rasterelektronenmikroskopischen Untersuchung mit etwa 6.000-facher Vergrößerung
- Fig. 12: die Oberflächenaufnahme der Wendeschneidplatte nach Fig. 11 in einer rasterelektronenmikroskopischen Untersuchung mit etwa 6.000-facher Vergrößerung
- Fig. 13: die Schliffaufnahme einer nach Beispiel 7 erfindungsgemäß beschichteten Wendeschneidplatte in einer lichtmikroskopischen Untersuchung mit etwa 1.500-facher Vergrößerung
- Fig. 14: die Schliffaufnahme einer nach Beispiel 8 nach dem Stand der Technik beschichteten Wendeschneidplatte in einer lichtmikroskopischen Untersuchung mit etwa 1.500-facher Vergrößerung
- Fig. 15: die Bruchaufnahme des Gefüges der Wendeschneidplatte nach Fig. 14 in einer rasterelektronenmikroskopischen Untersuchung mit etwa 6.000-facher Vergrößerung
- Fig. 16: die Oberflächenaufnahme der Wendeschneidplatte nach Fig. 14 in einer rasterelektronenmikroskopischen Untersuchung mit etwa 6.000-facher Vergrößerung
- Fig. 17: das Verschleißdiagramm eines vergleichenden Fräsversuches zwischen einer Wendeschneidplatte die nach Beispiel 7 und einer Wendeschneidplatte die nach Beispiel 8 beschichtet wurde

### Beispiel 1

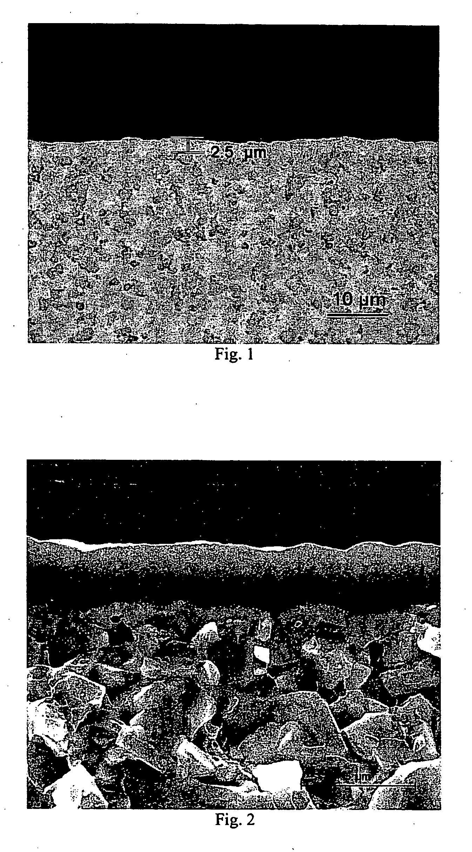

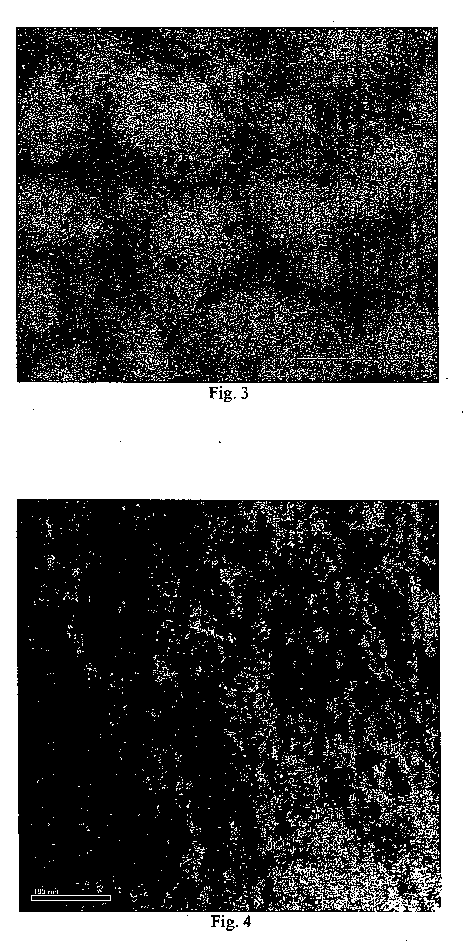

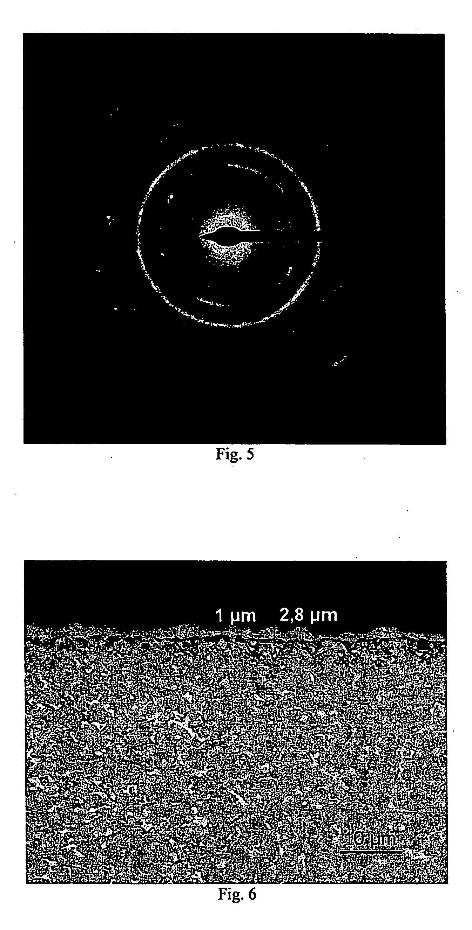

In einem Graphitsuszeptor mit 200 mm Durchmesser und 280 mm Höhe wurden Wendeschneidplatten aus Hartmetall erfindungsgemäß mit einer Gaszusammensetzung aus 10 Vol.% Wasserstoff, 0,4 Vol.% TiCl₄, 0,7 Vol.% BCl₃ und 88,9 Vol.% Argon 1 Stunde lang unter Normaldruck und bei einer Temperatur von 800°C durch ein thermisches CVD-Verfahren beschichtet. Dabei hat sich auf den Wendeschneidplatten eine etwa 2,5 µm starke, sehr gleichmäßige Titandiboridschicht ausgebildet.
Aus Figur 1 ist klar zu erkennen, dass die Randzone des Hartmetallsubstrates zur Titandiboridschicht hin völlig frei von einer η-Phase oder einer borhaltigen Diffusionszone ist.
Aus Figur 2 ist bereits die Feinkörnigkeit der Beschichtung klar ersichtlich, so dass die Korngröße nicht mehr erkennbar ist.
Aus Figur 3 ist ebenfalls die Feinkörnigkeit der Oberfläche zu ersehen, die so weit geht, dass aus dieser Figur keine exakten Korngrößen zu entnehmen sind. Um die Korngrößen exakter ermitteln zu können, wurde zusätzlich eine erfindungsgemäß beschichtete Wendeschneidplatte mittels TEM (Transmissionselektronenmikroskopie) untersucht.
Aus Figur 4 ist die extreme Feinkörnigkeit der Kristallstruktur mit einer mittleren Korngröße im Bereich von 10 - 30 nm zu erkennen.
Eine Elektronenbeugung der Probe ist in Figur 5 zu sehen und zeigt auch die Gleichförmigkeit der Kristallstruktur.

### Beispiel 2

Zu Vergleichszwecken wurden identische Wendeschneidplatten, wie sie auch nach Beispiel 1 beschichtet wurden, mit einem thermischen CVD-Beschichtungsverfahren nach dem Stand der Technik entsprechend der DE 25 25 185 beschichtet. Die Beschichtung erfolgte im gleichen Graphitsuszeptor wie in Beispiel 1 mit einer Gaszusammensetzung von 99,74 Vol.% Wasserstoff, 0,22 Vol.% TiCl₄ und 0,04 Vol.% BCl₃ 2 Stunden lang unter Normaldruck bei einer Temperatur von 1.000°C. Dabei wurde eine sehr unregelmäßige Titandiboridschicht ausgebildet, deren mittlere Schichtstärke etwa der Schichtstärke der nach Beispiel 1 hergestellten, erfindungsgemäßen Schicht, entspricht.
In Figur 6 ist die Unregelmäßigkeit dieser Schicht sowie deren Inhomogenität klar zu erkennen. Darüber hinaus weist die Randzone des Hartmetallsubstrates eine stark ausgeprägte η-Phase auf.

In einem Fräsversuch wurden die nach Beispiel 1 und 2 beschichteten Wendeschneidplatten miteinander verglichen.

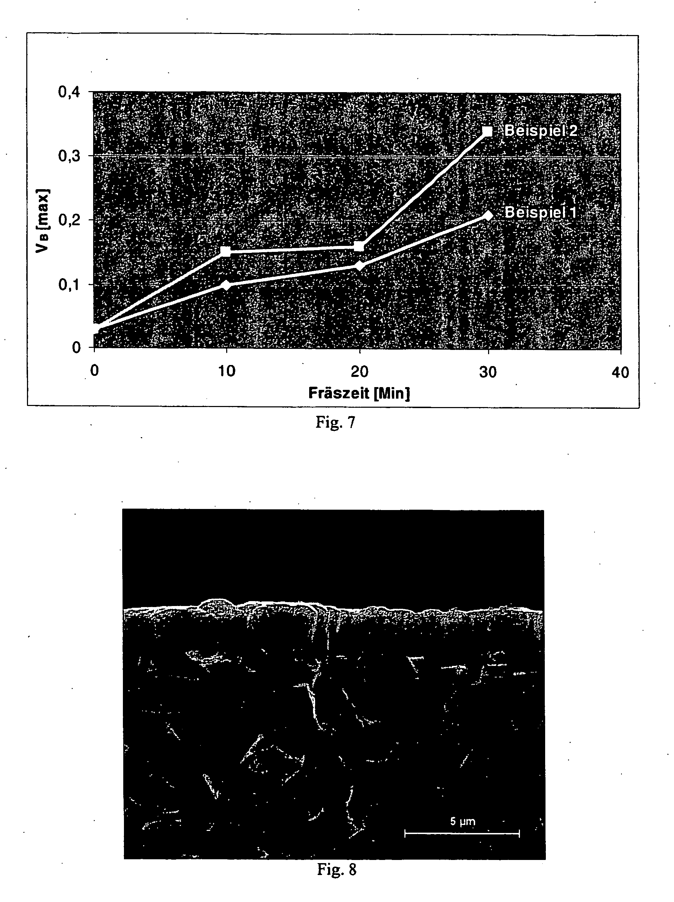

Figur 7 zeigt die Standzeiten der entsprechenden Wendeschneidplatten beim Fräsen einer TiAl6V4-Titanlegierung unter den Schnittbedingungen v_{c} = 50 m/min, f_{z} = 0,12 mm, aₚ = 5 mm, aₑ = 49,9 mm, mit Kühlung.
Bei der nach Beispiel 2 beschichteten Wendeschneidplatte nach dem Stand der Technik ist die kritische Verschleißgröße V_{B} [max] von 0,3 mm bereits nach 27 Minuten Fräszeit erreicht, während die erfindungsgemäß nach Beispiel 1 beschichtete Wendeschneidplatte nach 30 Minuten Fräszeit erst einen Verschleiß von 0,2 mm aufweist, d.h. der Verschleiß der Wendeschneidplatte nach dem Stand der Technik ist um mehr als 30 % höher als bei der erfindungsgemäß beschichteten.

### Beispiel 3

Zu Vergleichszwecken wurden identische Wendeschneidplatten, wie sie auch nach Beispiel 1 beschichtet wurden, mittels eines PVD-Verfahrens nach dem Stand der Technik mit einer Titandiboridschicht mit einer Stärke von etwa 2,5 µm, vergleichbar mit der Schichtstärke gemäß Beispiel 1, beschichtet. Figur 8 zeigt die stängelige Struktur dieser Titandiboridschicht.

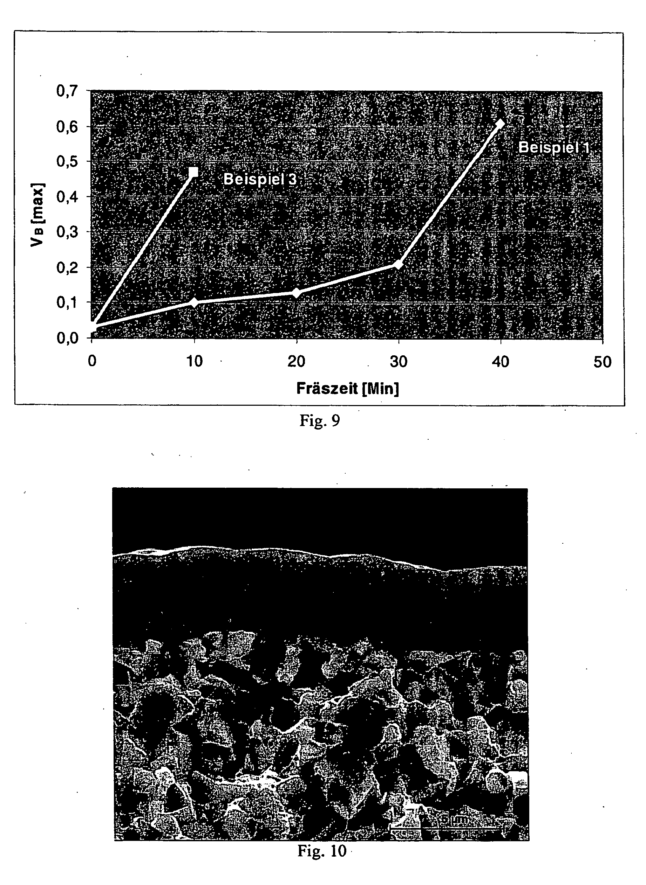

In einem Fräsversuch unter denselben Bedingungen wie vorstehend, im Vergleich der Beispiele 1 und 2 beschrieben, wurden die Standzeiten der nach Beispiel 1 und Beispiel 3 beschichteten Wendeschneidplatten entsprechend der Figur 9 miteinander verglichen. Bezogen auf eine kritische Freiflächenverschleißbreite V_{B} [max] von 0,3 mm wurde dabei mit der nach dem Stand der Technik gemäß Beispiel 3 beschichteten Wendeschneidplatte eine Standzeit von 6,4 Minuten erreicht, während mit der erfindungsgemäß nach Beispiel 1 beschichteten Wendeschneidplatte eine Standzeit von 32,3 Minuten erreicht, was einer Steigerung der Verschleißfestigkeit um das 5-fache entspricht.

### Beispiel 4

Identische Wendeschneidplatten, wie in Beispiel 1, wurden in derselben Beschichtungsanlage wie in Beispiel 1 erfindungsgemäß mit einem thermischen CVD-Verfahren in einem ersten Schritt mit einer etwa 1 µm starken Titannitridschicht beschichtet. Anschließend wurde unter denselben Bedingungen wie in Beispiel 1 mit Ausnahme der Beschichtungsdauer, die in diesem Beispiel 75 Minuten betrug, eine etwa 3 µm starke, erfindungsgemäße Titandiboridschicht abgeschieden.
Figur 10 zeigt die bekannte säulenförmige Struktur der Titannitridschicht sowie die extrem feinkörnige Struktur der darüber liegenden Titandiboridschicht.

### Beispiel 5

Identische Wendeschneidplatten wie in Beispiel 1, wurden in derselben Beschichtungsanlage wie in Beispiel 1 erfindungsgemäß mit einem thermischen CVD-Verfahren wie in Beispiel 4 in einem ersten Schritt mit einer etwa 1 µm starken Titannitridschicht beschichtet. Anschließend wurde unter denselben Bedingungen wie in Beispiel 1 mit Ausnahme der Beschichtungsdauer, die in diesem Beispiel 65 Minuten betrug, eine etwa 2,6 µm starke erfindungsgemäße Titandiboridschicht abgeschieden. Anschließend wurde auf die Titandiboridschicht noch eine etwa 1 µm starke Titannitridschicht abgeschieden. Die derart beschichteten Wendeschneidplatten wurden abschließend durch eine Strahlbehandlung mit einer Kupferlegierung mit einer entsprechenden, ca. 0,2 µm starken Deckschicht überzogen.

In einem Fräsversuch unter denselben Bedingungen wie vorstehend im Vergleich der Beispiele 1 und 2 beschrieben, wurden die Standzeiten der nach Beispiel 4 und Beispiel 5 beschichteten Wendeschneidplatten ermittelt. Mit der nach Beispiel 4 erfindungsgemäß beschichteten Wendeschneidplatte wurde, bezogen auf eine kritische Freiflächenverschleißbreite V_{B} [max] von 0,3 mm eine Standzeit von 30,3 Minuten erreicht, während mit der nach Beispiel 5 erfindungsgemäß beschichteten Wendeschneidplatte eine Standzeit von 37,8 Minuten erreicht wurde.

### Beispiel 6

Für Vergleichszwecke wurden identische Wendeschneidplatten, wie sie auch nach Beispiel 1 beschichtet wurden, mit einem thermischen CVD-Beschichtungsverfahren nach dem Stand der Technik entsprechend der EP 0 015 451 in derselben Beschichtungsanlage wie in Beispiel 1 mit einer etwa 3 µm starken Titandiboridschicht beschichtet. Dazu wurde ein Gasgemisch mit der Zusammensetzung 94,7 Vol.% Wasserstoff, 3,3 Vol.% BCl₃ und 2 Vol.% TiCl₄ verwendet. Die Beschichtungsdauer betrug 45 Minuten bei einer Temperatur von 800°C.

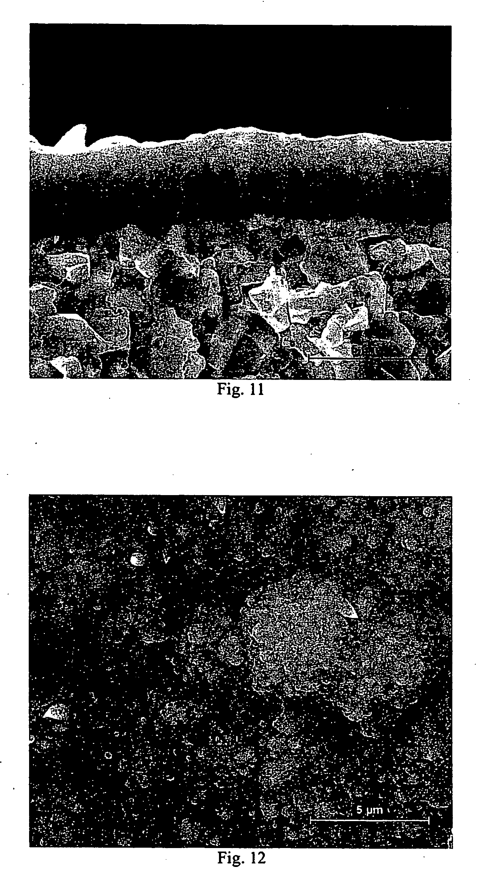

Die Figuren 11 und insbesondere Figur 12 zeigen deutlich die grobkörnige Struktur der Schicht mit einer Korngröße von etwa 0,5 - 1 µm.

### Beispiel 7

Identische Wendeschneidplatten wie in Beispiel 1 wurden erfindungsgemäß mit einem thermischen CVD-Verfahren mit derselben Gaszusammensetzung wie in Beispiel 1 30 Minuten lang unter Normaldruck bei einer Temperatur von 800°C beschichtet. Dabei hat sich auf den Wendeschneidplatten eine etwa 1,2 µm starke, sehr gleichmäßige Titandiboridschicht ausgebildet.

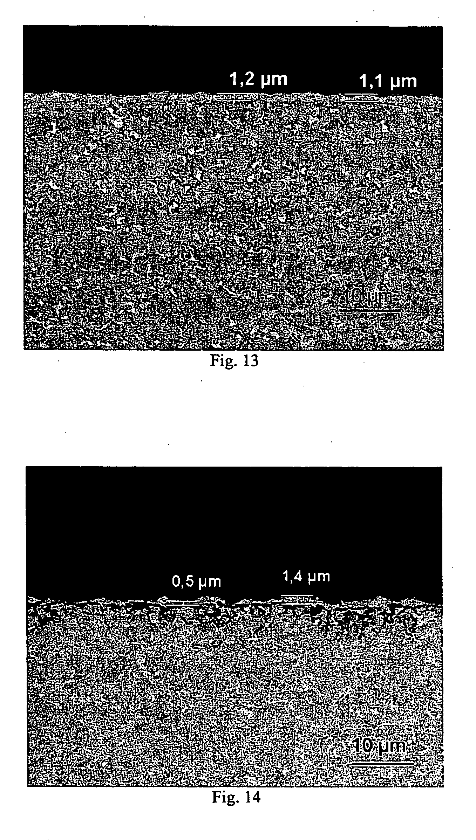

Figur 13 zeigt die Gleichmäßigkeit der Beschichtung. Außerdem ist zu erkennen, dass die Randzone des Hartmetallsubstrates völlig frei von einer η-Phase ist und auch keine borhältige Diffusionszone aufweist.

### Beispiel 8

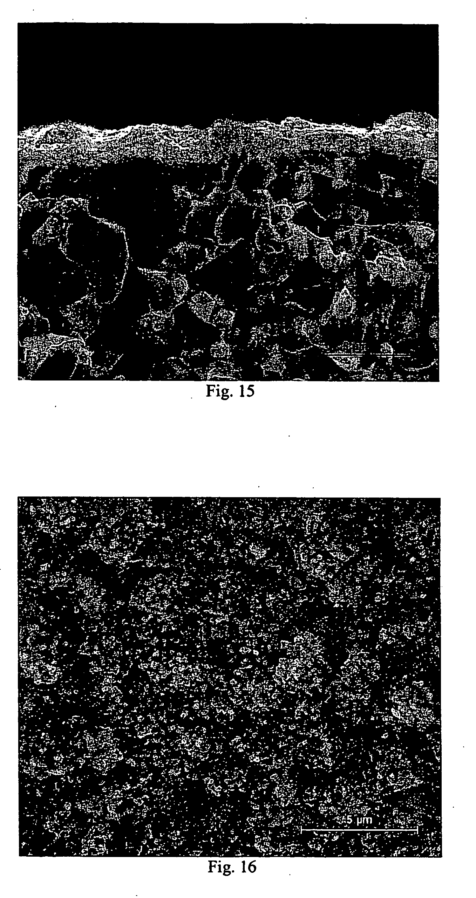

Für Vergleichszwecke wurden identische Wendeschneidplatten, wie sie auch nach Beispiel 1 beschichtet wurden, mit einem thermischen CVD-Beschichtungsverfahren in derselben Beschichtungsanlage, wie in Beispiel 1, nach dem Stand der Technik entsprechend der DE 25 25 185 beschichtet. Die Beschichtung erfolgte im gleichen Graphitsuszeptor wie in Beispiel 1 mit derselben Gaszusammensetzung und denselben Beschichtungsbedingungen wie in Beispiel 2, mit der Ausnahme, dass die Beschichtungszeit nur 1 Stunde betrug. Dabei wurde eine sehr unregelmäßige Titandiboridschicht mit einer maximalen Schichtstärke von 1,4 µm ausgebildet. Die Figuren 14 und 15 zeigen die starke Unregelmäßigkeit der Schicht. Darüber hinaus ist aus Figur 14 eine stark ausgeprägte η-Zone in der Randzone des Hartmetallsubstrates zu erkennen.
Figur 16 zeigt die grobkörnige Struktur der Oberfläche, wobei die Korngröße im Bereich von 0,5 - 1 µm liegt.

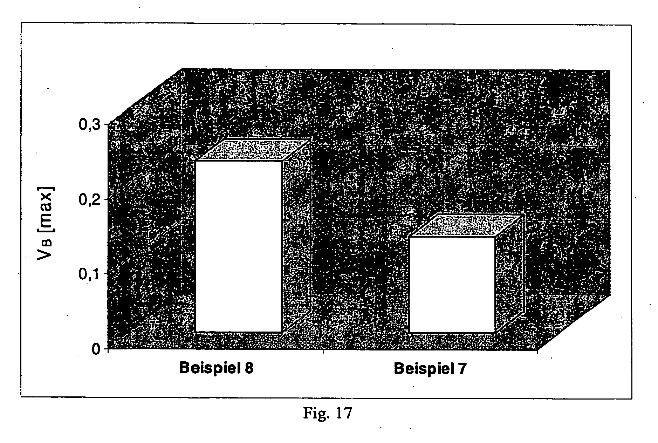

In einem Fräsversuch wurden unter denselben Bedingungen wie bei den vorangegangenen Fräsversuchen die Standzeiten der nach Beispiel 7 und Beispiel 8 beschichteten Wendeschneidplatten ermittelt.
Wie aus der Figur 17 zu ersehen ist, liegt die Freiflächenverschleißbreite V_{B} nach einer Fräslänge von 400 mm bei der erfindungsgemäß nach Beispiel 7 beschichteten Wendeschneidplatte bei 0,1 mm, während sie bei der nach dem Stand der Technik entsprechend Beispiel 8 beschichteten Wendeschneidplatte bei 0,2 mm liegt, was bedeutet, dass diese Wendeschneidplatte doppelt so schnell verschleißt.

## Patentansprüche

1. Werkzeug für die spanabhebende Bearbeitung bestehend aus einem Substratmaterial und aus einer ein- oder mehrlagigen Hartstoffschicht, wobei die Hartstoffschicht mindestens eine durch ein thermisches CVD-Verfahren abgeschiedene, mindestens 0,1 µm dicke Titandiboridschicht umfasst,
**dadurch gekennzeichnet,**
**dass** die Titandiboridschicht ein feinkörniges Gefüge mit einer mittleren Korngröße von maximal 50 nm aufweist und keine borhaltige Diffusionszone im Substratmaterial vorliegt.

2. Werkzeug für die spanabhebende Bearbeitung nach Anspruch 1, **dadurch gekennzeichnet, dass** die Titandiboridschicht eine Schichtstärke im Bereich von 0,1 µm bis 15 µm, insbesondere im Bereich von 1 µm bis 10 µm aufweist.

3. Werkzeug für die spanabhebende Bearbeitung nach Anspruch 1 oder 2, **dadurch gekennzeichnet, dass** das Substratmaterial Hartmetall ist.

4. Werkzeug für die spanabhebende Bearbeitung nach einem der Ansprüche 1 bis 3, **dadurch gekennzeichnet, dass** das Werkzeug eine Wendeschneidplatte ist.

5. Werkzeug für die spanabhebende Bearbeitung nach einem der Ansprüche 1 bis 4, **dadurch gekennzeichnet, dass** die Hartstoffschicht mehrlagig ist und die Titandiboridschicht im Wechsel mit einer oder mehreren anderen Hartstoffschichten vorliegt.

6. Werkzeug für die spanabhebende Bearbeitung nach Anspruch 5, **dadurch gekennzeichnet, dass** der Schichtaufbau der Hartstoffschicht, beginnend von der Substratoberfläche, aus einer oder mehreren Schichten aus der Gruppe Titannitrid, Titankarbonitrid und Titankarbobornitrid mit einer Gesamtschichtstärke im Bereich von 0,1 µm bis 3 µm, gefolgt von einer 1 µm bis 5 µm dicken Titandiboridschicht, besteht.

7. Werkzeug für die spanabhebende Bearbeitung nach Anspruch 5 oder 6, **dadurch gekennzeichnet, dass** auf der Titandiboridschicht noch eine Deckschicht aus einer oder mehreren Schichten aus der Gruppe Titannitrid, Titankarbonitrid und Titankarbobornitrid mit einer Gesamtschichtstärke im Bereich von 0,1 bis 3 µm aufgebracht ist.

8. Werkzeug für die spanabhebende Bearbeitung nach einem der Ansprüche 1 bis 7, **dadurch gekennzeichnet, dass** die Oberfläche der Hartstoffbeschichtung durch eine Strahlbehandlung mit einem oder mehreren Metallen aus der Gruppe Aluminium, Kupfer, Zink, Titan, Nickel, Zinn oder aus Basislegierungen dieser Metalle, behandelt ist.

9. Verwendung eines Werkzeuges für die spanabhebende Bearbeitung nach einem der Ansprüche 1 bis 8 zur zerspanenden Bearbeitung von nicht eisenhaltigen Werkstoffen wie Titan , Aluminium und deren Legierungen.

10. Verfahren zur Herstellung eines Werkzeuges für die spanabhebende Bearbeitung nach einem der Ansprüche 1 bis 8, wobei die Beschichtung durch ein thermisches CVD-Verfahren bei einer Temperatur im Bereich von 700°C bis 950°C hergestellt wird, **dadurch gekennzeichnet, dass** zur Herstellung der Titandiboridschicht ein Gasgemisch verwendet wird, das aus 2,5 bis 50 Vol.% Wasserstoff, 0,1 bis 10 Vol.% TiCl₄ und 0,2 bis 20 Vol.% BCl₃, Rest Intergas, vorzugsweise Argon, besteht.

11. Verfahren zur Herstellung eines Werkzeuges für die spanbhebende Bearbeitung nach Anspruch 10, **dadurch gekennzeichnet, dass** zur Herstellung der Titandiboridschicht ein Gasgemisch mit der Zusammensetzung 5 bis 20 Vol.% Wasserstoff, 0,2 bis 1 Vol.% TiCl₄, 0,4 bis 2 Vol.% BCl₃, Rest Inertgas, vorzugsweise Argon, verwendet wird und die Beschichtung unter Normaldruck erfolgt.

12. Verfahren zur Herstellung eines beschichteten Gegenstandes nach Anspruch 10 oder 11; **dadurch gekennzeichnet, dass** das Gasgemisch zunächst ohne den BCl₃ Anteil in den Reaktionsraum eingeleitet wird und nach einem Zeitraum von 0,5 bis 5 Minuten der BCl₃ Anteil zugemischt wird.

## Claims

1. A cutting tool, consisting of a substrate material and a hard material coating having one or more layers, the hard material coating comprising at least one titanium diboride layer which is deposited by a thermal CVD method and is at least 0.1 µm thick,
**characterized in that**
the titanium diboride layer has a fine-grained structure with an average grain size of at most 50 nm and
no boron-containing diffusion zone is present.

2. The cutting tool as claimed in claim 1, **characterized in that** the titanium diboride layer has a layer thickness in the range of from 0.1 µm to 15 µm, particularly in the range of from 1 µm to 10 µm.

3. The cutting tool as claimed in claim 1 or 2, **characterized in that** the substrate material is cemented carbide.

4. The cutting tool as claimed in any one of claims 1 to 3, **characterized in that** the tool is an indexable cutting insert.

5. The cutting tool as claimed in any one of claims 1 to 4, **characterized in that** the hard material coating has a plurality of layers, and the titanium diboride layer is provided in alternation with one or more other hard material layers.

6. The cutting tool as claimed in claim 5, **characterized in that** the layer structure of the hard material coating, starting from the substrate surface, consists of one or more layers from the group titanium nitride, titanium carbonitride and titanium carboboronnitride with a total layer thickness in the range of from 0.1 µm to 3 µm, followed by a 1 µm to 5 µm thick titanium diboride layer.

7. The cutting tool as claimed in claim 5 or 6, **characterized in that** a cover layer consisting of one or more layers from the group titanium nitride, titanium carbonitride and titanium carboboronnitride with a total layer thickness in the range of from 0.1 µm to 3 µm is furthermore applied on the titanium diboride layer.

8. The cutting tool as claimed in any one of claims 1 to 7, **characterized in that** the surface of the hard material coating is treated by a blasting treatment with one or more metals from the group aluminum, copper, zinc, titanium, nickel, tin or base alloys of these metals.

9. The use of a cutting tool as claimed in any one of claims 1 to 8 for the machining of materials which do not contain iron, such as titanium, aluminum and alloys thereof.

10. A method for producing a cutting tool as claimed in any one of claims 1 to 8, wherein the coating is produced by a thermal CVD method at a temperature in the range of from 700°C to 950°C, **characterized in that** a gas mixture which consists of from 2.5 to 50 vol.% hydrogen, from 0.1 to 10 vol.% TiCl₄ and from 0.2 to 20 vol.% BCl₃, the remainder being inert gas, preferably argon, is used for producing the titanium diboride layer.

11. The method for producing a cutting tool as claimed in claim 10, **characterized in that** a gas mixture having the composition 5 to 20 vol.% hydrogen, 0.2 to 1 vol.% TiCl₄, 0.4 to 2 vol.% BCl₃, the remainder being inert gas, preferably argon, is used for producing the titanium diboride layer, and the coating process is carried out under normal pressure.

12. The method for producing a coated object as claimed in claim 10 or 11, **characterized in that** the gas mixture is initially introduced into the reaction space without the BCl₃ component, and the BCl₃ component is added after a period of from 0.5 to 5 minutes.

## Revendications

1. Outil pour usinage par enlèvement de copeaux, composé d'un matériau de substrat et d'un revêtement en matière dure appliqué en une ou plusieurs couches, dans lequel ledit revêtement comprend au moins une couche de diborure de titane d'une épaisseur d'au moins 0,1 µm déposée par procédé CVD thermique, caractérisé, premièrement, en ce que la couche de diborure de titane présente une structure à grains fins avec une grosseur moyenne de grain maximale de 50 nm et, deuxièmement, par l'absence, dans le matériau de substrat, d'une zone de diffusion contenant du bore.

2. Outil pour usinage par enlèvement de copeaux selon la revendication 1, **caractérisé en ce que** l'épaisseur de la couche de diborure de titane est comprise entre 0,1 µm et 15 µm, en particulier entre 1 µm et 10 µm.

3. Outil pour usinage par enlèvement de copeaux selon la revendication 1 ou 2, **caractérisé en ce que** le matériau de substrat est un métal dur.

4. Outil pour usinage par enlèvement de copeaux selon l'une quelconque des revendications 1 à 3, **caractérisé en ce que** ledit outil est un insert de coupe amovible.

5. Outil pour usinage par enlèvement de copeaux selon l'une quelconque des revendications 1 à 4, **caractérisé en ce que** le revêtement en matière dure comprend plusieurs couches et **en ce que** la couche de diborure de titane est présente en alternance avec une ou plusieurs autres couches de matière dure.

6. Outil pour usinage par enlèvement de copeaux selon la revendication 5, **caractérisé en ce que** la structure multi-couches du revêtement en matière dure est constituée, à partir de la surface du substrat, d'une ou de plusieurs couches d'une matière du groupe nitrure de titane, carbonitrure de titane et carbo-boronitrure de titane présentant une épaisseur totale comprise entre 0,1 µm et 3 µm, suivies d'une couche de diborure de titane d'une épaisseur comprise entre 1 µm et 5 µm.

7. Outil pour usinage par enlèvement de copeaux selon la revendication 5 ou 6, **caractérisé en ce que** la couche de diborure de titane est surmontée d'une couche de surface composée d'une ou de plusieurs couches d'une matière du groupe nitrure de titane, carbonitrure de titane et carboboronitrure de titane présentant une épaisseur totale comprise entre 0,1 µm et 3 µm.

8. Outil pour usinage par enlèvement de copeaux selon l'une quelconque des revendications 1 à 7, **caractérisé en ce que** la surface du revêtement en matière dure est soumise à un traitement par grenaillage avec un ou plusieurs métaux du groupe aluminium, cuivre, zinc, titane, nickel, étain, ou avec des alliages à base desdits métaux.

9. Utilisation d'un outil selon l'une quelconque des revendications 1 à 8, pour l'usinage par enlèvement de copeaux de matériaux non ferrifères tels que le titane, l'aluminium et les alliages de ces derniers.

10. Procédé de fabrication d'un outil pour usinage par enlèvement de copeaux selon l'une quelconque des revendications 1 à 8, dans lequel le revêtement est réalisé par un procédé CVD thermique, sous une température comprise entre 700 et 950 degrés Celsius, **caractérisé en ce qu'**il est utilisé, pour la réalisation de la couche de diborure de titane, un mélange de gaz composé pour 2,5 à 50 pour cent en volume d'hydrogène, pour 0,1 à 10 pour cent en volume de TiCl₄, pour 0,2 à 20 pour cent en volume de BCl₃ et, pour le reste, d'un gaz inerte, de préférence de l'argon.

11. Procédé de fabrication d'un outil pour usinage par enlèvement de copeaux selon la revendication 10, **caractérisé en ce qu'**il est utilisé, pour la réalisation de la couche de diborure de titane, un mélange de gaz composé pour 5 à 20 pour cent en volume d'hydrogène, pour 0,2 à 1 pour cent en volume de TiCl₄, pour 0,4 à 2 pour cent en volume de BCl₃ et, pour le reste, d'un gaz inerte, de préférence de l'argon, et **en ce que** le dépôt du revêtement est effectué sous pression atmosphérique.

12. Procédé de fabrication d'un objet doté d'un revêtement selon la revendication 10 ou 11, **caractérisé en ce que**, dans un premier temps, le mélange de gaz est introduit dans l'espace de réaction sans la part de BCl₃ et que cette dernière est ajoutée au mélange après une période comprise entre 0,5 et 5 minutes.
